(19) **Europäisches Patentamt European Patent Office Office européen des brevets**

(11) **EP 3 439 169 A1**

(12) # EUROPEAN PATENT APPLICATION
published in accordance with Art. 153(4) EPC

(43) Date of publication:
06.02.2019 Bulletin 2019/06

(21) Application number: 17773387.0

(22) Date of filing: 14.03.2017

(51) Int Cl.:
*H02S 10/30* (2014.01)

(86) International application number:
PCT/IB2017/051470

(87) International publication number:
WO 2017/168277 (05.10.2017 Gazette 2017/40)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
MA MD

(30) Priority: 28.03.2016 RU 2016111201

(71) Applicants:
• Kirsanov, Anatolii Ivanovich
Moscow 117638 (RU)
• Strebkov, Dmitry Semenovich
Moscow 125047 (RU)

(72) Inventors:
• PANCHENKO, Vladimir Anatolevich
Pavlovskij Posad
Moskovskaya obl. 142500 (RU)
• KIRSANOV, Anatolii Ivanovich
Pavlovskij Posad
Moskovskaya obl. 142500 (RU)
• STREBKOV, Dmitry Semenovich
Pavlovskij Posad
Moskovskaya obl. 142500 (RU)

(74) Representative: Lapienis, Juozas
MSP Europe UAB
21-92 Seimyniskiu Str.
09236 Vilnius (LT)

(54) **HYBRID SOLAR ROOF PANEL**

(57) The invention relates to a roof panel device with built-in solar modules for use on the roofs of buildings and structures. A hybrid solar roof panel is mounted on the roof of a building and comprises: a body with a protective coating on its working surface, said protective coating being in the form of an optical deflection system, consisting of a set of prisms, which is hit by the rays of the sun at an input angle $\beta_0$; a semi-parabolic cylindrical mirror reflector; and a radiation receiver in the form of a strip mounted between the focal axis and the vertex of the semi-parabolic cylindrical mirror reflector. The radiation receiver is in the form of a hybrid solar cogeneration photovoltaic module with a second protective coating, said protective coating being mounted at an angle of ≤90° to the protective coating of the hybrid solar roof panel and forming, with the body of the hybrid roof panel, a sealed cavity, filled with a polysiloxane gel and containing a radiation receiver consisting of concentrating solar elements, the sealed cavity side of the outer wall of the body being provided with channels containing built-in pipes for circulating a heat transfer medium.

[Fig. 1]

## Description

### Technical field

The present invention relates to a roof panel device with built-in solar modules for use on the roofs of buildings and structures.

### Prior art

A roof panel with a solar battery comprising a bearing base in the form of a curved surface with the solar battery mounted thereon based on semiconductor photovoltaic converters with a current collection electric cable is known. The solar battery is disposed on a flat ground buried to a depth of up to 20 mm relative to the base upper surface and shielded with a sealing curing composition up to the base upper surface with solar radiation transmission level being not less than 30 % within an operation range of the solar battery (the RF Patent No. 2194827 published on 20.12.2002).

The drawback of the known roof panel is a high consumption of semiconductor material for photovoltaic converters and a low solar panel capacity due to optical losses in the sealing composition.

A roof solar panel produced by HEDA Solar (PRC) which includes built-in solar modules composed of four or eight commutated Si-solar cells with dimensions of 156×156 mm or 125×125 mm is known. The roof solar panel has a protective cover made of tempered glass and an electrical capacity of 8-20 W, an operational voltage of 1-2 V depending on the number of solar cells (catalogue of HEDA Solar www.hedasolar.com).

The drawback of the known roof solar panel is a high consumption of solar silicon for solar cells and a high cost.

A solar module with solar energy concentrator mounted on the roof and the facade of a building and comprising a flat protective transparent enclosure and a radiation receiver in the form of a strip is known, wherein the radiation receiver is mounted on the flat transparent enclosure in the focus of a line-focus cylindrical concentrator, the concentrator being in the form of an asymmetrical reflector consisting of two different-sized parts divided by a symmetry axis extending through the vertex and the focal axis of the reflector, wherein the major part of the reflector is configured as a half of a parabolic cylindrical (hereinafter - semi-parabolic cylindrical) reflector, and the minor part is configured as a circular cylindrical reflector with a radius being equal to a distance from the focal axis to the vertex of the semi-parabolic cylindrical reflector, the focal axis being displaced towards one of the protective enclosure sides parallel to its base and coinciding with an edge of the radiation receiver's strip.

The drawback of the known solar module is that a protective roof cover should be mounted on the roof under the solar module to protect buildings and structures from exposure to external effects, which increases the cost of buildings and structures.

A roof solar panel mounted on the roof of a building or a structure is known, wherein a normal to the roof surface is in a meridian plane, wherein the roof solar panel comprises a body having an internal cavity with a protective coating on working surface, on which solar radiation falls at a ray entrance angle $\beta_0$, and receivers consisting of commutated solar elements, wherein a compound concentrator is mounted in the cavity of the body 1 under the protective coating, the compound concentrator being in the form of a radiation-transparent optical deflection system consisting of a plurality of prisms with an acute angle $\Psi$ between the surface of entrance and exit of rays and more than one semi-parabolic cylindrical mirror reflectors with a parametric angle $\delta$ having the surfaces of entrance and exit of rays, wherein the focal regions of all semi-parabolic cylindrical mirror reflectors are displaced towards the lower or upper side of the roof solar panel, and the radiation receivers consisting of commutated solar elements are disposed parallel to the focal axis and perpendicular to the plane of the roof solar panel between the focal axis and a mirror surface of each semi-parabolic cylindrical mirror reflector, wherein the planes of ray entrance surface of the optical deflection system and the planes of ray entrance surface of semi-parabolic cylindrical mirror reflector are parallel to the plane of the protective coating, and a ray entrance angle $\beta_0$, an acute angle $\Psi$ and a refracting index n of a material of the optical deflection system are related to a parametric angle $\delta$ of semi-parabolic cylindrical reflector with the relation being expressed by the following:

$$\beta_0 = arcsin\left\{\left\{\left\{sin\left\{\left\{arcsin\left\{sin\left[90° - 2\delta + \Psi\right]\frac{1}{n}\right\} - \Psi\right\}\right\}n\right\}\right\}\right\}.$$

(The RF Patent No. 2557272 published on 20.07.2015)

The drawback of the known roof solar panel is that an additional solar module should be provided for hot water supply and heating of buildings.

A hybrid photovoltaic module for electric power and heat energy generation comprising a protective glass coating, connected solar elements located between the glass and a body having a heat exchanger is known, wherein the solar elements are electrically-insulated from the heat exchanger, a space between the solar elements and the heat exchanger, as well as between the glass coating and the heat exchanger is filled with a layer of siloxane gel with a thickness of 0.5-5 mm, wherein the protective glass coating is made in the form of an evacuated glass unit consisting of two glasses with a vacuum clearance of 0.1-0.2 mm with a vacuum of $10^{-3}$ - $10^{-5}$ mm of mercury, wherein the heat exchanger is made in the form of an hermetically sealed chamber with fittings for heat-carrying agent circulation, and the total area of the connected solar elements is commensurable with the area of an upper base of the heat exchanger's body. (the RF Patent No. 2546332 published on 10.04.2015).

The drawback of the known solar module is a high consumption of solar elements and heat exchanger materials and a low temperature of heat-carrying agent during exposure to non-concentrated solar radiation.

**Technical problem**

The object of the invention is to provide a hybrid roof solar panel with a high optical efficiency and a low consumption of semiconductor material and a low cost during electric power and heat energy generation.

The technical result consists in increasing efficiency of use of solar energy in the roof solar panel and reducing the cost of electric power and heat energy generation.

**Technical problem solution**

The said technical result is achieved in that in a hybrid roof solar panel mounted on the building roof a normal to the roof surface is in a meridian plane, wherein the hybrid roof solar panel comprises a body and a protective coating on the working surface which is in the form of an optical deflection system composed of a set of prisms, on which solar radiation falls at a ray entrance angle $\beta_0$, a semi-parabolic cylindrical mirror reflector and a radiation receiver in the form of a strip mounted between the focal axis and the vertex of the semi-parabolic cylindrical mirror reflector, wherein the radiation receiver is in the form of a hybrid cogeneration solar photovoltaic module with a second protective coating mounted at an angle of $\leq 90°$ relative to the protective coating of the hybrid roof solar panel, the second protective coating and the body of the hybrid roof solar panel forming an hermetically sealed cavity filled with polysiloxane gel, in which the radiation receiver composed of commutated solar elements is located, wherein the external wall of the body on the side of the hermetically sealed cavity comprises channels, in which built-in pipes for heat-carrying agent circulation are located, wherein the body of the hybrid roof solar panel and the pipes outside the body are provided with heat insulation, wherein the hybrid roof solar panel comprises electrical and hydraulic receptacles for connection with the adjacent hybrid roof solar panels.

In an embodiment of the hybrid roof solar panel, pipes for heat-carrying agent circulation are in the form of metal-filled plastic pipes for heated flooring with a heat conductivity coefficient of not less than

$$0.43\frac{W}{m^2 \cdot °K}.$$

In another embodiment of the hybrid roof solar panel, pipes for heat-carrying agent circulation are made of metal in the interior of the housing and of metal-filled plastic outside the housing of the hybrid roof solar panel.

In an embodiment of the hybrid roof solar panel, heat insulation of the body and the pipes for heat-carrying agent circulation is made by means of liquid paint of RE-TERM type.

In an embodiment of the hybrid roof solar panel pipes for heat-carrying agent circulation are mounted in a horizontal plane along the full width of the roof and are connected to the bodies of all hybrid roof solar panels mounted in one row.

In another embodiment of the hybrid roof solar panel pipes for heat-carrying agent circulation are mounted in a vertical plane and are connected to the bodies of all hybrid roof solar panels mounted in one row in a vertical plane.

In an embodiment of the hybrid roof solar panel, the body of the hybrid roof solar panel is made of heat-conducting plastic.

In another embodiment of the hybrid roof solar panel, the body of the hybrid roof solar panel is made of heat-conducting ceramic.

In another embodiment of the hybrid roof solar panel, the body of the hybrid roof solar panel is made of a heat-conducting mixture of sand and plastic.

In an embodiment of the hybrid roof solar panel the internal cavity of the body is moulded such that it contains a protective coating, a semi-parabolic cylindrical mirror reflector, an optical deflection system and receivers composed of commutated solar elements.

In an embodiment of the hybrid roof solar panel, the semi-parabolic cylindrical mirror reflector has flat moulded sections parallel to the focal axis with the width of these sections in a meridian plane being commensurable with or exceeding the width of the receiver composed of commutated solar elements.

In an embodiment of the hybrid roof solar panel, the mirror coating of the semi-parabolic cylindrical mirror reflector is made in the form of a metal film with a thickness of 0.1-5 mm applied onto the flat moulded sections of the body's internal cavity.

In an embodiment of the hybrid roof solar panel, the semi-parabolic cylindrical mirror reflector is composed of planar mirror bevels the planes of which run parallel to the focal axis with the width of these bevels in a meridian plane being commensurable with or exceeding the width of the receiver composed of commutated solar elements.

In an embodiment of the hybrid roof solar panel, the side walls of the internal shaping cavity of the body for containing a semi-parabolic cylindrical mirror reflector are positioned in a meridian plane and are provided with a mirror reflecting coating.

In an embodiment of the hybrid roof solar panel, the body is provided with a panel to ensure cable connection between the receiver composed of commutated solar elements and a marshalling box which is mounted in the body's cavity between the semi-parabolic cylindrical mirror reflector on the reverse side of the roof solar panel, and the marshalling box is provided with a conductor cable for commutation with other roof solar panels.

In an embodiment of the hybrid roof solar panel on the reverse side outside the body there are channels for mounting a pipe with the heat-carrying agent and laying a conductor cable to the neighbouring roof solar panels.

In an embodiment of the hybrid roof solar panel the hermetically sealed cavity with the radiation receiver is located on the roof in an upper part of the body, and a tilt angle of the protective coating relative to the horizontal surface when mounted on the roof equals $\theta_1 = \varphi - 23.5°$, where $\varphi$ is the latitude of the terrain, and an angle between the direction to the Sun and the horizontal surface equals $\gamma_1 = 90° - \theta_1 - \beta_0$, where $\beta_0$ is a ray entrance angle.

In another embodiment of the hybrid roof solar panel the hermetically sealed cavity with the radiation receiver is located on the roof in a lower part of the body, and a tilt angle of the protective coating relative to the horizontal surface when mounted on the roof equals $\theta_2 = \varphi + 23.5°$, where $\varphi$ is the latitude of the terrain, and an angle between the direction to the Sun and the horizontal surface equals $\gamma_2 = 90° - \theta_2 + \beta_0$, where $\beta_0$ is a ray entrance angle.

In yet another embodiment of the hybrid roof solar system in the upper part of the roof the hermetically sealed cavity with the radiation receiver is located in the upper part of the body, and a tilt angle of the protective coating relative to the horizontal surface is $\theta_1 = \varphi - 23.5°$, whereas in the lower part of the roof the hermetically sealed cavity with a radiation receiver is located in the lower part of the body, and a tilt angle of the protective coating relative to the horizontal surface is $\theta_2 = \varphi + 23.5°$, where $\varphi$ is the latitude of the terrain.

In one embodiment of the hybrid roof solar panel a liquid, for example, water or an antifreeze agent is used as a heat-carrying agent.

In another embodiment of the hybrid roof solar panel the air is used as a heat-carrying agent.

The essence of the invention is described in Figures 1, 2, 3, 4, 5, 6, 7, 8, where Fig. 1 shows a general view outside the hybrid roof solar panel. Fig. 2 shows a general view on the reverse side of the panel, in which pipes for heat-carrying agent circulation are mounted in a horizontal plane. Fig. 3 shows a longitudinal cross-sectional view of the hybrid roof solar panel in a meridian plane. Fig. 4 shows the optical scheme and a ray path in the hybrid roof solar panel. Fig. 5 shows mounting of a hybrid roof solar panel on the building roof to produce a maximum amount of energy in the summer. Fig. 6 shows mounting of a hybrid roof solar panel to produce a maximum amount of energy in the winter. Fig. 7 shows mounting of a hybrid roof solar panel to generate energy uniformly over the course of the year. Fig. 8 shows an electrical and hydraulic wiring diagram of a hybrid roof solar panel for electrical power supply and for hot water supply of the buildings.

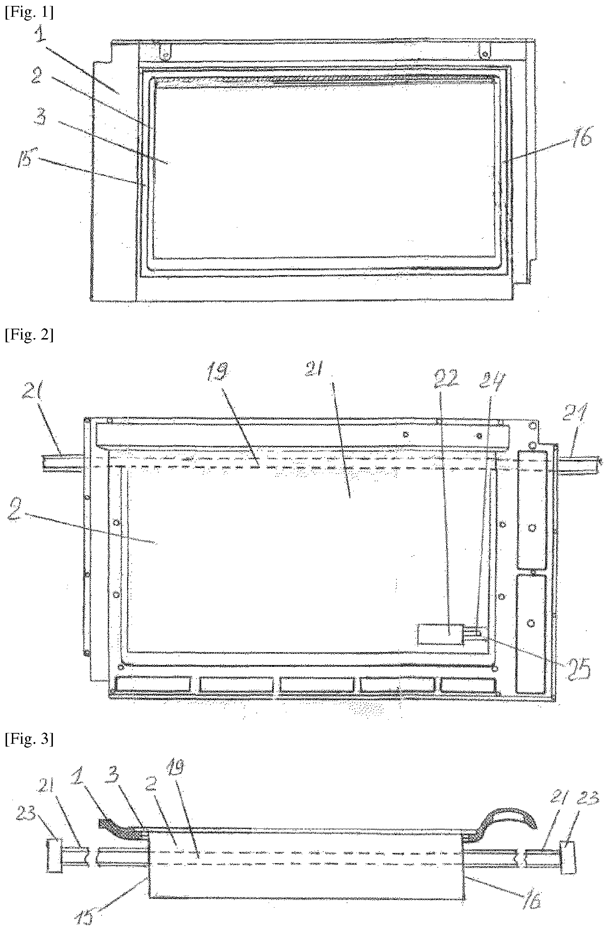

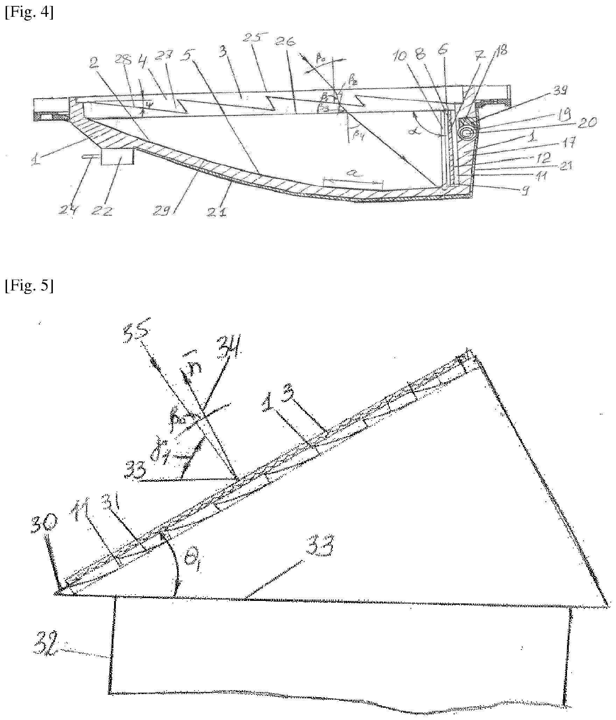

The hybrid roof solar panel shown in Fig. 1 has a body 1, in which a cavity 2 hermetically sealed on the reverse side (Fig. 2, 3) is formed to contain a protective coating 3 of a compound concentrator composed of an optical deflection system 4 (Fig. 4) and a semi-parabolic cylindrical mirror reflector 5, a receiver 6 consisting of commutated solar elements 7 mounted between the focal axis 8 and the vertex 9 of the semi-parabolic cylindrical mirror reflector 5. A second protective coating 10 made of glass or transparent plastic of the receiver 6 is mounted at an angle $\alpha \leq 90°$ relative to the plane of the protective coating 3. The second protective coating 10 and the body 1 of the hybrid roof solar panel form a second hermetically sealed cavity 11, in which the receiver 6 is positioned and which is filled with polysiloxane gel 12. Side walls 13 and 14 of the internal shaping cavity 2 of the body 1 are provided with mirror coatings 15 and 16. An external wall 17 of the body 1 on the side of the second hermetically sealed cavity 11 comprises channels 18, in which built-in pipes 19 with walls made of metal-filled plastic or metal for heat-carrying agent 20 circulation are located. The body 1 of the panel and the pipe 19 outside the body 1 are provided with heat insulation 21. The receiver 6 in the second hermetically sealed cavity 11 and channels 18 with pipes 19 for heat-carrying agent 20 circulation form a hybrid photovoltaic module, and the external wall 17 of the body 1 on the side of the second hermetically sealed cavity 11 perform functions of radiator for conducting heat from the receiver 6 to the heat-carrying agent 20. The hybrid roof solar panel has an electrical marshalling box 22 and hydraulic receptacles 23 for connection with the adjacent hybrid roof solar panels. The marshalling box 22 is mounted on the reverse side of the body 1 and has a conductor cable 24 for commutation with other roof solar panels. Outside the body 1 on the reverse side there are channels 25 for laying the cable 24 and channels 18 for placing the pipe 19 with the heat-carrying agent 20. The plane of the entrance surface 25 of the rays of the optical deflection system 4 and the plane of the entrance surface 26 of the rays of the semi-parabolic cylindrical mirror reflector 5 are parallel to the plane of the protective coating 3.

As shown in Fig. 4 the optical deflection system 4 is composed of a plurality of prisms 27 directed in one direction with an acute angle $\Psi$ between the surface 25 of entrance and a surface 28 of exit of rays.

Fig. 4 shows ray path in the compound concentrator consisting of the optical deflection system 4 and the semi-parabolic cylindrical mirror reflector 5, where $\beta_0$ is the angle of ray entrance on the surface 25 of entrance to the optical deflection system 4, $\beta_1$ is the angle of ray refraction in the surface 25 of entrance inside the optical deflection system 4, $\beta_2$ is the angle between ray and a normal to the surface 28 of exit of rays inside the optical deflection system 4, $\beta_3$ is the angle of ray exit on the surface 28 of exit outside the optical deflection system 4, $\beta_4$ is the angle of ray entrance at the surface 26 of entrance of the semi-parabolic cylindrical mirror reflector 4.

Angles $\beta_0$, $\beta_1$, $\beta_2$, $\beta_3$, and $\beta_4$ are the angles between the direction of rays and the normal to the respective surface. Since surfaces 25 and 26 of ray entrance are parallel, the angle $\beta_0$ responsible for cosine losses is equal to the angle $\beta_4$ between the direction of rays of entrance into the semi-parabolic cylindrical mirror reflector 5 and the surface 26 of entrance of the semi-parabolic cylindrical mirror reflector 5 with parametric angle $\delta$.

$$\beta_4 = 90^o - 2\delta \tag{1}$$

$$\beta_3 = \beta_4 + \psi \tag{2}$$

$$\beta_2 = \arcsin\left[ (\sin\beta_3)\frac{1}{n} \right] \tag{3}$$

$$\beta_1 = \beta_2 - \psi \tag{4}$$

$$\beta_0 = \arcsin\left[ (\sin\beta_1)\cdot n \right] \tag{5}$$

$$\beta_0 = \arcsin\left\{ \left\{ \left\{ \sin\left\{ \left\{ \arcsin\left\{ \sin\left[ 90^o - 2\delta + \psi \right]\frac{1}{n} \right\} - \psi \right\} \right\} n \right\} \right\} \right\} \tag{6}$$

The semi-parabolic cylindrical mirror reflector 5 in Fig. 4 is in the form of a metallized mirror film 29 with a thickness of 0.1-5 mm applied to the internal surface of the cavity 2 of the body 1, which comprises flat moulded sections *a* on the internal surface of the cavity 2 of the body 1 parallel to the focal axis 8. The width of flat sections *a* in a meridian plane is commensurable with the width *d* of the receiver 6 composed of commutated solar elements 7 which ensures a uniform illumination of the receiver 6 and prevents overheating of local sections of the receiver 6. In an embodiment of the structure, the semi-parabolic cylindrical mirror reflector 5 is made of polished aluminium foil.

As shown in Fig. 5 roof solar panels are mounted on a southern pitch 30 of a roof 31 of a building 32, the hermetically sealed cavity 11 with the radiation receiver is positioned on the roof 31 in the upper part of the body 1, and a tilt angle of the protective coating 3 of the roof solar panel to the horizontal surface 33 when mounted on the roof 31 is $\theta_1 = \varphi - 23.5°$, where $\varphi$ is the latitude of the terrain. Whereby, the normal 34 to the surface of the protective coating 3 in a meridian plane is directed to the position of the Sun at midday on June 22, on the day of summer solstice. The angle between the direction to the Sun 35 and the horizontal surface 33 at a given time equals $\gamma_1 = 90° - \varphi - 23.75° - \beta_0 = 90° - \theta_1 - \beta_0$. When mounted this way, the roof solar panel receives a maximum amount of solar energy in the summer period.

As the height of the Sun position decreases the amount of incoming solar energy will decrease in proportion to cos $\beta_0$.

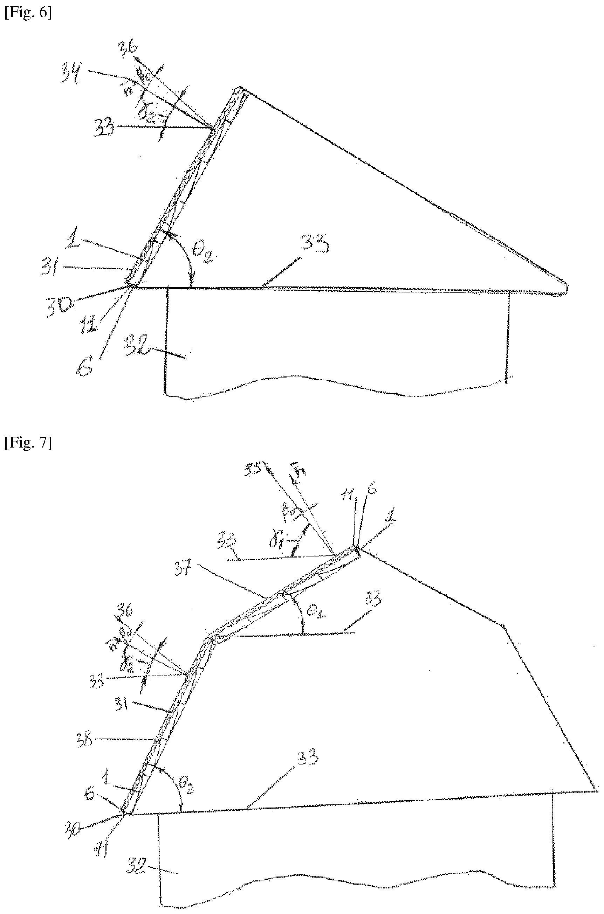

As shown in Fig. 6 the roof solar panels are mounted on the southern pitch 30 of the roof 31 of the building 32, such that a maximum amount of incoming solar energy is utilized in the winter period. The hermetically sealed cavity 11 with the receiver 6 is positioned in the lower part of the body 1, and a tilt angle of the protective coating 3 of the roof solar panel relative to the horizontal surface 33 when mounted on the roof 31 is $\theta_2 = \varphi + 23.5°$. Whereby, the normal 34 to the surface of the protective coating 3 in a meridian plane is directed to the position of the Sun at midday on December 22. The angle between the direction to the Sun 36 and the horizontal surface 33 at any given time equals $\gamma_2 = 90° - \varphi + 23.75° + \beta_0 = 90° - \theta_2 + \beta_0$.

As shown in Fig. 7 the building roof has two sections 37 and 38 with different slopes to the horizontal surface. In the upper part of the roof at section 37 the hermetically sealed cavity 11 with the receiver 6 is located in the upper part of the body 1, and a tilt angle of the protective coating relative to the horizontal surface 33 is $\theta_1 = \varphi - 23.5°$. In the lower part of the roof at the section 38 the hermetically sealed cavity 11 with the radiation receiver 6 is located in the lower part of the body 1 of the hybrid roof solar panel, and a tilt angle of the protective coating 3 relative to the horizontal surface 33 is $\theta_2 = \varphi + 23.5°$. The angles between the direction to the Sun and the horizontal surface are equal to:

$$\gamma_1 = 90^\circ - \theta_1 - \beta_0,$$

$$\gamma_2 = 90^\circ - \theta_2 + \beta_0.$$

Such an arrangement of hybrid roof solar panels allows for a more uniform generation of electrical power and hot water throughout the year compared to an arrangement of the hybrid roof solar panel as shown in Fig. 5 and 6.

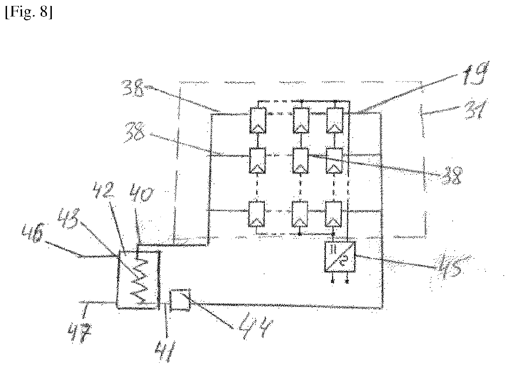

As shown in Fig. 8 the pipes 19 made of metal-filled plastic are arranged horizontally along the full width of the southern pitch of the roof 31 in each row 38 of the installation of hybrid roof solar panels. When mounting the hybrid roof solar panels on the roof 31 the pipes 19 made of metal-filled plastic are inserted to the channels 18 on the reverse side 23 of the body 1 of each panel (Fig. 2, 3, 4) and are fixed in the channel 18 with a special-purpose cover 39 to ensure a tight contact of the pipe 19 made of metal-filled plastic with the body 1 of the panel. The pipes 19 made of metal-filled plastic of the adjacent rows 38 arranged horizontally are connected to each other sequentially or in a parallel way along the edges of the roof 31. An inlet fitting 40 and outlet fitting 41 of the system of pipes 19 on the roof 31 are connected to a storage tank 42 to the heat-exchanger 43 inside the storage tank 42 mounted in the building. For circulation of the heat-carrying agent 20 through the panels at the outlet of the heat-exchanger 43 an electrical pump 44 operated by the hybrid roof solar panels is mounted. From the storage tank 42 hot water is supplied to the building through the pipes 46 and 47.

The hybrid roof solar panels are connected to each other via a marshalling box 22 by cable 24 in parallel and in series to obtain voltage 12 V - 96 V, and to the inverter 45 for connecting to the electrical grid. Where appropriate, between panels and the inverter 45 a storage battery with a charging controller is mounted (not shown in Fig. 8).

The hybrid roof solar panel operates as follows (Fig. 3). Solar radiation through the protective coating 3 is received at an angle $\beta_0$ on the surface 25 of ray entrance of the optical deflection system 4 composed of a set of prisms 27 with an acute angle $\Psi$, with refracting index n, enters the prism 27 at an angle $\beta_1$, exits the prism 27 at an angle $\beta_3$ and is received at the surface 26 of the entrance of semi-parabolic cylindrical mirror reflector 5 at an angle $\beta_4$, is reflected from semi-parabolic cylindrical mirror reflector 5 and is received by the receiver 6 provided that $\beta_4 \geq 90° - 2\delta$.

Cosine losses due to the deviation of solar flux from the normal to the ray entrance surface 25 of semi-parabolic cylindrical mirror reflector 5:

$$P = 1 - \cos\beta_0 \qquad (7)$$

Calculations by using the formulae (1)-(7) for $\delta = 26.1°$ are given in the table 1.

Table 1

| $\Psi$ | 0 | 8° | 12° | 16° | 20° | 24° | 28° | 32° |
|---|---|---|---|---|---|---|---|---|
| $\beta_0$ | 37.8° | 31.7° | 28.44° | 25° | 21.55° | 17.8° | 13.9° | 9.73° |
| P | 0.21 | 0.15 | 0.12 | 0.094 | 0.07 | 0.048 | 0.029 | 0.014 |

According to the table 1, the proposed construction of a hybrid roof solar panel enables to reduce cosine losses compared with the prototype from 21% ($\Psi = 0$) to 4.8% under $\Psi = 24°$. The effective aperture angle provided when the optical deflection system 4 is present increases from $\delta$ to the value of $\delta = \dfrac{90° - \beta_0}{2}$. For $\Psi = 24°$ $\beta_0 = 17.8°$ the effective aperture angle of a solar module with a concentrator is increased from $\delta = \dfrac{90° - 37.8°}{2} = 26.1$ to $\dfrac{90° - 17.8°}{2} = 36.1°$, which in the event of a change in Sun altitude by 7.83° in a month corresponds to an increase in the duration of operation in a steady-state mode from $\dfrac{26.1°}{7.83°} \cdot 2 = 6.7$ months to $\dfrac{36.1°}{7.83°} \cdot 2 = 9.22$ months.

Solar radiation concentration ratio in the hybrid roof solar panel, considering cosine losses equals:

$$\kappa = \frac{2\cos\beta_0}{1 - \cos(2\delta)}.$$

The roof solar panel operates in a steady-state mode without sun tracking and collects on the receiver 6 direct and diffuse solar radiation within an aperture angle $\delta$.

Exemplary implementation of a roof solar panel.

The optical deflection system 4 consists of a set of prisms 27 with an acute angle $\Psi = 24°$. Ray entrance angle $\beta_0 = 17.8°$, angle $\beta_4 = 37.8°$, aperture angle $\delta$ of semi-parabolic cylinder mirror reflector 5 made of polished aluminium is $\delta = 26.1°$. The receiver 6 has dimensions of $78\times624$ mm, is composed of four silicon solar elements 7 with dimensions of $78\times156$ mm connected in a parallel way. The geometrical concentration ratio $K = 4.92$, cosine losses are 4.8%, the optical efficiency is 80%, the efficiency of the receiver 6 is 15%. The active area of the roof solar panel for use of solar energy is 0.192 m$^2$. The electrical efficiency considering optical losses is 10%. The peak electric power is 20 W under an intensity of illumination of 1 kW/m$^2$ and a temperature of 25°. Receiver 6 is provided with a heat-exchange device to generate electric power and produce hot water or hot air. When using the heat-carrying agent 20 in the form of hot water the overall efficiency will be 40%, capacitance rate will be 30 W with water temperature being 65°C. The yearly amount of incoming solar energy in Krasnodar Territory, Anapa, received on the southern pitch 30 of the roof 31 at an angle of 40° to horizontal surface is 1680 kW·h/m$^2$. The hybrid roof solar panel with a total electric power of 1 kW mounted on the roof generates electric power in the amount of 1680 kW·h and heat energy in the amount of 5040 kW·h as hot water per annum.

Under a cost of semi-parabolic cylindrical mirror reflectors being 5.20 USD/m$^2$, a concentration of 4.92, an optical efficiency of 0.8 and an electrical efficiency of 15% the cost of a roof solar panel will be 30 USD, or 1.5 USD/W, at the current cost of 3 USD/W, that is, there will be a decrease by 2 times, whereas the cost of compound concentrator and receiver 6 will be approximately equal and will amount to 50% of the cost of the roof solar panel.

In comparison with the prototype the solar module with a concentrator has low cosine losses, a long service life and a low cost.

**Claims**

1.  A hybrid roof solar panel mounted on the roof of a building, wherein a normal to the roof surface is in a meridian plane, wherein the hybrid roof solar panel comprises a body and a protective coating on the working surface which is in the form of an optical deflection system composed of a set of prisms, on which solar radiation falls at a ray entrance angle $\beta_0$, a semi-parabolic cylindrical mirror reflector and a radiation receiver in the form of a strip mounted between the focal axis and the vertex of the semi-parabolic cylindrical mirror reflector, **characterized in that** the radiation receiver is in the form of a hybrid cogeneration solar photovoltaic module with a second protective coating mounted at an angle of $\leq 90°$ relative to the protective coating of the hybrid roof solar panel, the second protective coating and the body of the hybrid roof solar panel forming an hermetically sealed cavity filled with polysiloxane gel, in which the radiation receiver composed of commutated solar elements is located, wherein an external wall of the body on the side of the hermetically sealed cavity comprises channels, in which built-in pipes for heat-carrying agent circulation are located, wherein the body of the hybrid roof solar panel and the pipes outside the body are provided with heat insulation, wherein the hybrid roof solar panel comprises electrical and hydraulic receptacles for connection with the adjacent hybrid roof solar panels.

2. The hybrid roof solar panel according to claim 1, **characterized in that** the pipes for heat-carrying agent circulation are configured in the form of metal-filled plastic pipes for heated flooring with a heat conductivity coefficient of not less than

$$0.43 \frac{W}{m^{2} \cdot {}^{\circ}K}.$$

3. The hybrid roof solar panel according to claim 1, **characterized in that** the pipes for heat-carrying agent circulation are made of metal in the interior of the body and of metal-filled plastic outside the body of the hybrid roof solar panel.

4. The hybrid roof solar panel according to claim 1, **characterized in that** the heat insulation of the body and the pipes for heat-carrying agent circulation is made by means of liquid paint of RE-TERM type.

5. The hybrid roof solar panel according to claim 1, **characterized in that** the pipes for heat-carrying agent circulation are mounted in a horizontal plane along the full width of the roof and are connected to the bodies of all hybrid roof solar panels mounted in one row.

6. The hybrid roof solar panel according to claim 1, **characterized in that** the pipes for heat-carrying agent circulation are mounted in a vertical plane and are connected to the bodies of all hybrid roof solar panels mounted in one row in a vertical plane.

7. The hybrid roof solar panel according to claim 1, **characterized in that** the body of the hybrid roof solar panel is made of heat-conducting plastic.

8. The hybrid roof solar panel according to claim 1, **characterized in that** the body of the hybrid roof solar panel is made of heat-conducting ceramic.

9. The hybrid roof solar panel according to claim 1, **characterized in that** the body of the hybrid roof solar panel is made of a heat-conducting mixture of sand and plastic.

10. The hybrid roof solar panel according to claim 1, **characterized in that** the internal cavity of the body is moulded so as to contain the protective coating, the semi-parabolic cylindrical mirror reflector, the optical deflection system and the receiver composed of commutated solar elements.

11. The hybrid roof solar panel according to claim 1, **characterized in that** the semi-parabolic cylindrical mirror reflector has flat moulded sections parallel to the focal axis, the width of these sections in a meridian plane being commensurable with or exceeding the width of the receiver composed of commutated solar elements.

12. The hybrid roof solar panel according to claim 1 or claim 11, **characterized in that** the mirror coating of the semi-parabolic cylindrical mirror reflector is made in the form of a metal film with a thickness of 0.1-5 mm applied onto the flat moulded sections of the body's internal cavity.

13. The hybrid roof solar panel according to claim 1, **characterized in that** the semi-parabolic cylindrical mirror reflector is composed of planar mirror bevels, the planes of which run parallel to the focal axis, the width of the mirror bevels in a meridian plane being commensurable with or exceeding the width of the receiver composed of commutated solar elements.

14. The hybrid roof solar panel according to claim 1, **characterized in that** the side walls of the internal shaping cavity of the body configured to contain the semi-parabolic cylindrical mirror reflector are positioned in a meridian plane and are provided with a mirror reflecting coating.

15. The hybrid roof solar panel according to claim 1, **characterized in that** the body is provided with a panel to ensure a cable connection between the receiver composed of commutated solar elements and a marshalling box, which is mounted in the body's cavity between the semi-parabolic cylindrical mirror reflector on the reverse side of the roof solar panel, and the marshalling box is provided with a conducting cable for commutation with other roof solar panels.

16. The hybrid roof solar panel according to claim 1, **characterized in that** the hermetically sealed cavity with the radiation receiver is located on the roof in the upper part of the body, and a tilt angle of the protective coating relative to the horizontal surface when mounted on the roof equals $\theta_1 = \varphi - 23.5°$, where $\varphi$ is the latitude of the terrain, and an angle between the direction to the sun and the horizontal surface equals $\gamma_1 = 90° - \theta_1 - \beta_0$, where $\beta_0$ is a ray entrance angle.

17. The hybrid roof solar panel according to claim 1, **characterized in that** the hermetically sealed cavity with the radiation receiver is located on the roof in the lower part of the body, and a tilt angle of the protective coating relative to the horizontal surface when mounted on the roof equals $\theta_2 = \varphi + 23.5°$, where $\varphi$ is the latitude of the terrain, and an angle between the direction to the sun and the horizontal surface equals $\gamma_2 = 90° - \theta_2 + \beta_0$, where $\beta_0$ is a ray entrance angle.

18. The hybrid roof solar panel according to claim 1, **characterized in that** in the upper part of the roof the hermetically sealed cavity with the radiation receiver is located in the upper part of the body, and a tilt angle of the protective coating relative to the horizontal surface is $\theta_1 = \varphi - 23.5°$, whereas in the lower part of the roof the hermetically sealed cavity with the radiation receiver is located in the lower part of the body, and a tilt angle of the protective coating relative to the horizontal surface is $\theta_2 = \varphi + 23.5°$, where $\varphi$ is the latitude of the terrain.

19. The hybrid roof solar panel according to claim 1, **characterized in that** a liquid, for example, water or an antifreeze agent, is used as a heat-carrying agent.

20. The hybrid roof solar panel according to claim 1, **characterized in that** air is used as a heat-carrying agent.

[Fig. 1]

[Fig. 2]

[Fig. 3]

[Fig. 4]

[Fig. 5]

[Fig. 6]

[Fig. 7]

[Fig. 8]

# EP 3 439 169 A1

## INTERNATIONAL SEARCH REPORT

| | International application No. |
|---|---|
| | PCT/IB 2017/051470 |

**A. CLASSIFICATION OF SUBJECT MATTER**

H02S 10/30 (2014.01)

According to International Patent Classification (IPC) or to both national classification and IPC

**B. FIELDS SEARCHED**

Minimum documentation searched (classification system followed by classification symbols)

H02S 10/00, 10/30, 20/23, 40/20, F24J 2/00

Documentation searched other than minimum documentation to the extent that such documents are included in the fields searched

Electronic data base consulted during the international search (name of data base and, where practicable, search terms used)

PatSearch (RUPTO internal), USPTO, PAJ, Esp@cenet, DWPI, EAPATIS, PATENTSCOPE

**C. DOCUMENTS CONSIDERED TO BE RELEVANT**

| Category* | Citation of document, with indication, where appropriate, of the relevant passages | Relevant to claim No. |
|---|---|---|
| A | RU 2557272 C1 (STREBKOV DMITRII SEMENOVICH et al.) 20.07.2015 | 1-20 |
| A | RU 2576072 C2 (STREBKOV DMITRII SEMENOVICH et al.) 27.02.2016 | 1-20 |
| A | RU 2576752 C2 (FEDERALNOE GOSUDARSTVENNOE BIUDZHETNOE NAUCHNOE UCHREZHDENIE "VSEROSSIISKII NAUCHNO-ISSLEDOVATELSKII INSTITUT ELEKTRIFIKATSII SELSKOGO KHOZIAISTVA" (FGBNU VIESKH)) 10.03.2016 | 1-20 |
| A | US 8215298 B2 (FRITZ KLOTZ) 10.07.2012 | 1-20 |

| ☐ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 19 June 2017 (19.06.2017) | 20 July 2017 (20.07.2017) |

| Name and mailing address of the ISA/ | Authorized officer |
|---|---|
| | |
| Facsimile No. | Telephone No. |

Form PCT/ISA/210 (second sheet) (July 1998)

14

## REFERENCES CITED IN THE DESCRIPTION

**Patent documents cited in the description**

- WO 2194827 A
- WO 2546332 A